# EUROPEAN PATENT APPLICATION

(11) **EP 1 122 993 A2**
(43) Date of publication of application: **08.08.2001**
(21) Application number: 01300533.5
(22) Date of filing: 22.01.2001
(51) Int. Cl.: H05K 9/00

(54) **Noise cancellation by addition of phase shifted signal**

(30) Priority: 04.02.2000 US 498078
(71) Applicant: LUCENT TECHNOLOGIES INC., Murray Hill, New Jersey 07974-0636 (US)
(72) Inventor: Bethea, Clyde George, Franklin Park, NJ 08823 (US); Franey, John Philip, Bridgewater, NJ 08807 (US); Pernell, Timothy Lloyd, East Orange, NJ 07018 (US)
(74) Representative: Buckley, Christopher Simon Thirsk

(57) **Abstract**

For reducing noise emissions from an electrical circuit that generates a periodic primary signal (22) which is radiated as a form of noise, a conductive body (32) is placed to enclose the electrical circuit or at least block a noise emission path (26). A phase shift circuit (42) responsive to the primary signal produces a cancellation signal (50) as an output that is synchronous with the primary signal and is out of phase with the primary signal, preferably by 180 degrees, or is inverted relative to the primary signal. The output of the phase shift circuit can be frequency dependent and is preferably attenuated to obtain an amplitude of the cancellation signal that is substantially equal to the current electromagnetically induced in the conductive body by the primary signal. Thus noise emission along the noise emission path is reduced or canceled at the conductive body by nulling the current induced in the conductive body due to radiated noise.

## Description

### FIELD OF THE INVENTION

The invention relates to the field of suppression of electromagnetic signals, and in particular to shielding against propagation of electromagnetic interference ("EMI") by generation of cancellation signals to null the effects of incident or generated signals.

According to the invention a cancellation signal is generated out of phase with the EMI, and is summed with the EMI signal such that the two interfere. Preferably the cancellation signal is 180 degrees out of phase with at least one component of the EMI signal, and equal in amplitude. The cancellation signal can be generated by sensing the induced EMI, for example in a feedback loop configured to minimize the EMI, or the cancellation signal can be generated as a function of a sensed signal that is related to the EMI signal, such as a synchronous signal at a circuit point that is indirectly coupled to the source of the EMI. The cancellation signal is used actively to drive a conductor associated with the EMI source, such as a whole or partial conductive enclosure or a radiating conductor disposed along the EMI propagation path, such as a conductive panel or an elongated antenna.

The cancellation signal frequency, amplitude and phase are preferably chosen to be precisely opposite from the EMI signal, such that the sum of the cancellation signal and the EMI signal is a null. Alternatively, the result can be diminished EMI propagation or complete cancellation only in certain conditions (e.g., at an average level).

In a feedback embodiment, the incident EMI signal can be sensed in a shield enclosure or receiving antenna and used as an input to a phase locked loop, phase adjustment circuit and amplifier or attenuator to control the amplitude, frequency and phase of the cancellation signal. Alternatively the cancellation signal can be generated from a circuit coupled either to the circuit responsible for emitting the EMI or to a signal that is otherwise related to the EMI. One or many frequency components and separate phase relationships can be employed to cancel one or more EMI frequency components. Additionally, the incidence or emission of EMI can be directionally controlled.

### BACKGROUND OF THE INVENTION

Various circuits generate electromagnetic interference or "EMI," and various circuits are subject to anomalous operation or damage due to incident EMI. It is known to enclose such circuits in a conductive enclosure or shield to attenuate electromagnetic radiation that either is emitted from or received by the circuits.

An incident EMI field induces a current in a conductive enclosure or shield according to principles of electromagnetic propagation. A current induced in a conductor is dissipated in part by eddy currents and resistive heating. However, a current induced in the conductor becomes a secondary source that also generates a propagating electromagnetic field. Typically the propagating signal from the conductor (e.g., a conductive shield) is attenuated compared to the original signal and is shifted in phase.

Typically, a conductive shield is coupled to a local circuit ground, which sinks current induced in the shield. A grounded conductive enclosure coupled to a local circuit ground is known as a Faraday Cage, and helps to attenuate passage of EMI that is incident on or is generated by a circuit. Such a conductive shield reduces but does not eliminate EMI. Currents induced in the conductive shield enclosure are conducted to ground and part of their energy is dissipated by resistive heating of the shield). Insofar as current continues to flow in the shield, the current in turn radiates an electromagnetic field.

An apparatus having various ground points such as shield enclosures effectively has a plurality of circuit grounds that may be of slightly different potential and are coupled together by conductive paths. The conductive paths between these grounds may have a rather low electrical resistance so that a modest potential difference between the grounds can produce substantial current flow between so-called ground points at different potentials. The current produces an electromagnetic field that propagates through space. The field strength of the propagating field as a function of its direction is determined by the geometry of the conductor carrying the current.

In most cases conductive shielding enclosures have at least small gaps due to the material they are made of or the manner of attachment of their parts. Some known enclosures are formed of conductive screen. Often, shielding enclosures are sheet metal box shapes. Gaps in the continuous conductive character of a shield enclosure around a source of interference or a device that is sensitive to interference may adversely affect shielding efficiency or the extent of attenuation.

In order to block or attenuate relatively high frequency radiation effectively, any gaps in a shielding enclosure such as a Faraday cage must be correspondingly small. Devices that operate or are affected by high frequencies and harmonics above a high base frequency can be difficult to shield. These include computing and radio communications equipment having high operational frequencies maintained for example by clock oscillators, multiplying phase locked loops and similar circuits. Square wave (digital) oscillators, counters and similar devices have outputs with high voltage slew rates (e.g., very short rise times), which correspond to frequency component that may be substantially higher than the digital clock or similar frequency. Even assuming that the basic clock frequency is at issue, the basic clock speed of a reasonably high performance personal computer, for example, is in the hundreds of megahertz, e.g., near 700MHz, and is likely to go higher with improvements in technology. These devices can emit EMI that affects other devices.

Transmission devices such as cellular telephones and microwave communication devices operate at high frequencies and high radiated power. Corresponding receivers may have high gain circuits rendering them sensitive to induced signals. Circuits of these and other types may have a basic or carrier or center frequency and a modulation frequency, which may vary and define (with the carrier) additional frequency components. Their operation emits radiated signals at these frequencies and at their harmonics. These and other signals can produce objectionable electromagnetic interference at one or more frequencies and in some instances may require intensive shielding attention.

The most common forms of shielding comprise sheet metal structures, usually forming boxes wholly or partly enclosing an interference source or circuit sensitive to interference. Conductive plastic materials and conductive coatings on non-conductive structures are also used. A normally-nonconductive plastic structure can be made conductive by including metal fibers or particles in the plastic, by applying a metallic coating layer, by laminating conductive and nonconductive sheets, etc. A connection between the conductive portion of the structure and the circuit is then made through a mounting fastener or conductive lead.

### SUMMARY OF THE INVENTION

The foregoing techniques rely on intersecting the path of propagation of EMI emissions or EMI incident signals by enclosing the EMI source or prospective destination in a passive Faraday cage that is grounded to sink and dissipate induced EMI currents. This technique requires attention to the shield structure and its grounding. Under the best circumstances, a portion of the incident EMI field passes the shield, and often gaps in the shield, potential differences between grounds and other considerations are such that the EMI is nevertheless passed or coupled to the circuit or its housing structure. What is needed is a technique for more actively blocking passage of noise emissions from an electrical circuit that generates a signal radiated as a form of noise. Such blocking can be accomplished according to the present invention by an active signal emitter placed adjacent to the circuit generating the noise or at some other position between that generating circuit and a circuit sensitive to the noise. A conductive body, which may be an antenna or a sheet or a full enclosure, is placed along the path of propagation of the noise signal. The EMI signal is sensed directly or indirectly and coupled to a phase shift circuit and driver that produces a cancellation signal output coupled to the conductive body. The cancellation signal output is substantially synchronous with the primary EMI signal and is out of phase with the primary signal. In a preferred embodiment, the conductive body comprises a sheet or box intersecting the path of propagation of the EMI, such that the EMI is induced in the conductive body. In that case the cancellation signal is produced as a driving signal 180 degrees out of phase from the signal induced in the conductive body and of equal amplitude. The conductive body thus forms a summing junction along the path of propagation, at which the EMI is canceled out and thus does not propagate further.

The output of the phase shift circuit can be frequency dependent for canceling EMI solely or preferentially at one or more particular frequency components. Preferably the phase shift circuit is coupled to the primary source signal responsible for emitting the EMI, which signal is attenuated as well as phase shifted so as to obtain a cancellation signal of the amplitude, frequency and opposite phase of the current electromagnetically induced in the conductive body by the primary signal.

### BRIEF DESCRIPTION OF THE DRAWINGS

These and other features and advantages of the invention are more fully disclosed or rendered apparent from the following description of certain preferred embodiments of the invention, that are to be considered together with the accompanying drawings wherein like numbers refer to like parts and further wherein:
FIG. 1 is a schematic illustration of the invention according to a first, simplified embodiment, and showing the addition of a cancellation signal with an induced EMI signal to block propagation of the EMI signal along a path.
FIG. 2 is a schematic illustration showing an alternative embodiment comprising a feedback loop.
FIG. 3 is a schematic illustration applying the invention to a shielding enclosure.
FIG. 4 is a schematic illustration applying the invention to protection of a circuit from incoming EMI.

### DETAILED DESCRIPTION

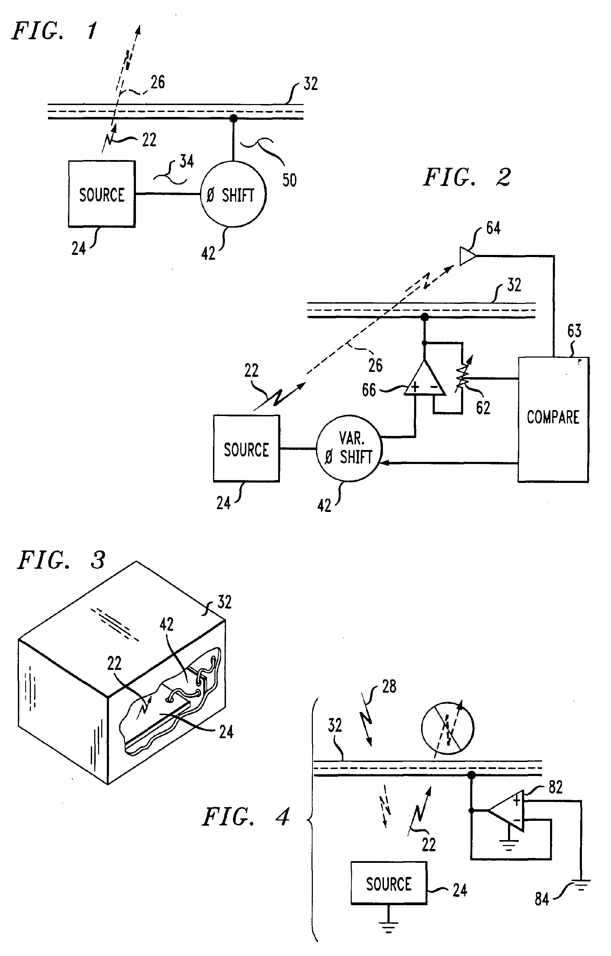

Referring now to the drawings wherein like characters designate like parts in each of the respective drawings, in FIGS. 1-4, an electromagnetic signal 22 is produced by operation of a first circuit 24 that forms the source of an electrical emission which propagates according to electromagnetic principles along a propagation path 26, shown in FIGS. 1 and 2. For any of various reasons it is desirable to prevent transmission of signal 22 along propagation path 26. For example, signal 22 may have deleterious effects on other circuits (not shown). A potential breach of security may occur if signal 22 carries information and is intercepted. The signal 22 may have adverse health effects, etc. For purposes of this disclosure, it is assumed that the electrical emission is an unwanted byproduct of a primary periodic signal produced by source 24 and is a substantially periodic signal having one or more stable or time varying frequency components. As shown by FIG. 4, the invention is applicable either to blocking outward transmission of EMI signals from a source or protecting a sensitive circuit along a propagation path from an incident EMI signal 28 produced by a remote source (not shown).

In any event, the invention provides an apparatus for adjusting an extent of electrical emission from a first circuit 24 that generates an substantially-periodic electromagnetic primary signal 24. Preferably the extent of electrical emission is adjusted to zero; however it is also possible to apply the invention to reducing the amplitude of the electrical emission rather than eliminating it. Similarly, a subset of the frequency components included in a primary signal 24 could be removed or reduced without affecting other components. The invention can be employed alone or in conjunction with other apparatus intended to protect or to isolate either an EMI source or a circuit sensitive to incident EMI.

According to the invention and as shown in Fig. 1, the apparatus includes a substantially conductive body or barrier 32 in which the primary signal induces a noise signal 34 synchronous with the primary signal 22. The noise signal is induced due to electromagnetic principles and may be attenuated and/or shifted in phase relative to the primary signal 22. In accordance with known physical rules, time-changing electric and magnetic fields produce potential differences and currents in a conductive body 32 upon which such fields are incident. Those fields and currents would continue to propagate along the EMI signal propagation path 26 as shown in FIG. 1, but for operation of the invention.

A phase shift circuit 42 is coupled to the first circuit, and is operable to produce an output in the form of an interference signal 50 that is related to the primary signal 22 and its induced noise signal 34. The interference signal 50 is coupled to conductive body 32 such that a cancellation signal that is out of phase with the noise signal is generated and is summed in conductive body 32 with the induced noise signal 34. Thus the cancellation signal and the noise signal at least partly nullify one another, thereby reducing or eliminating radiation of the noise signal beyond the conductive body 32 along propagation path 26.

The conductive body shown can be a conductive sheet such as a shield enclosure that extends across the propagation path 26 of noise signal 22 generated by the source 24 of the noise. The conductive body can wholly or partly enclose the source or circuit 24, for example comprising a sheet metal container or housing, a conductive plastic body, a conductively coated structure, a conductive screen or the like. Each of these structures forms a conductive barrier that is spaced from the source circuit 24 along a transmission path 26 along which the noise signal propagates and can form a node for summing of the signal with an interference signal 50 to reduce emissions. The conductive barrier can be continuous or foraminous and can comprise, for example, at least one of sheet metal, foraminous metal, fibrous metal, particulate conductive particles, conductive plastic, conductively-coated plastic and combinations thereof.

In FIG. 1, the noise signal is induced in the conductive body by the primary signal 22 due to electromagnetic propagation from the circuit 24 to the conductive body 32. It is also possible for the noise signal to be induced in the conductive body 32 due to electromagnetic propagation or due to conductive contact with a signal that is related to primary signal 24 rather than directly affected by the primary signal. Thus, for example, the noise signal may be induced by radiation from a signal that is synchronous with the primary signal 22 to which the phase shift circuit 42 is attached. For example, in an embodiment in which the propagating noise signal is produced by the output of a multi-stage amplifier or cascaded digital circuit, the phase shift can be obtained by coupling to a different stage of the amplifier or a different level in a cascaded circuit, in order to provide the interference signal necessary to cancel the induced noise at the point of conductive barrier 32 along propagation path 26.

The cancellation signal preferably is phase shifted 180 degrees relative to the noise signal produced by primary signal 22 in conductive body 32, and is coupled to the conductive body over a conductive connection to phase shift circuit 42. It is possible to reduce the amplitude of the noise signal, if not to eliminate it, if the phase shift is between 90 and 270 degrees and the amplitude of the cancellation signal is less than or equal to the amplitude of the induced noise. In that case the sum of the induced noise and the output of the phase shift circuit is less than the amplitude of the induced noise alone. Preferably, however, a 180 degree shift and an equal amplitude are employed to substantially cancel the noise without passing a portion of the noise and without generating additional frequency components due to beating of the induced noise and cancellation signals (namely at the sum and difference of the noise and cancellation signals).

In FIG. 2, an embodiment is disclosed which is responsive to variations in primary signal 22 from source 24. Normally, the propagation of a radiated noise signal is such that the induced noise signal is substantially attenuated relative to the primary signal. Thus, the phase shift circuit can include at least one attenuator 62 between the circuit 24 that is the source of the noise 22 and the conductive barrier 32 at which the noise and cancellation signals are summed. In this embodiment, a variable attenuator 62 is provided in a feedback loop associated with a drive amplifier 66 that is also responsive to an output of a comparator 63 responsive to a feedback sense antenna 64. In a feedback loop, the comparator controls the gain/attenuation of amplifier 66, which drives the cancellation signal induced in conductive body 32. The output of comparator 63 also can adjust the phase of the cancellation signal in this embodiment, by providing an input to a variable phase shift circuit 42. The amplitude of the noise signal that passes conductive barrier 32 along propagation path 26 is detected by antenna 64. The antenna 64 provides an input to the feedback elements including comparator 63, amplifier 66, and (optionally) phase shift circuit 42, which feedback elements seek to minimize the amplitude of the signal detected an antenna 64, namely the residual signal found along the path of propagation of the source signal.

The noise signal induced by radiation from or other electromagnetic coupling with the primary source of the noise may have components at a plurality of frequencies. In a frequency modulated signal, for example, the induced noise has components that are related to the carrier frequency and the modulation frequency (namely components at the sum and difference of such frequencies). The phase shift circuit can be operable to provide said interference signal and said cancellation signal at least at two said frequencies, each component of the interference/cancellation signal being out of phase with the corresponding components of the induced noise.

Referring to FIG. 2, the noise cancellation signal coupled to the conductive barrier across the propagation path can be driven wholly or partly from the source signal or wholly or partly from a signal detected in the conductive barrier (which is the sum of the noise signal and the generated cancellation signal). The signal detected in the conductive barrier can be the remainder of the noise signal after cancellation, namely the noise signal emitted in the event that the cancellation signal and the noise signal are not fully nulled. In that case, an antenna or other signal receiving conductor disposed further from the source along the signal propagation path than the conductive barrier can provide an input to the phase shift circuit in a feedback arrangement. A feedback signal can likewise be provided from a connection to the conductive barrier. In FIG. 2, the circuit that generates the cancellation signal that is summed with the noise signal induced in the conductive barrier comprises an inverter and attenuator operable to provide said cancellation signal at substantially equal amplitude and 180 degrees out of phase with the noise signal.

FIG. 3 illustrates a physical embodiment in which a signal source 24 is enclosed in a conductive enclosure 32 coupled by a phase shift 42 circuit according to the invention to the source 24. An all-around enclosure as shown, if actively driven according to the invention, may not effectively block escape of a noise signal 22 in all directions. For example, the noise signal may have a directional aspect (i.e., differences in power as a function of direction), such that driving the entire enclosure equally can over or under-correct in a particular direction. An outer conductive element that is a partial enclosure can be used to block propagation of the signal in one direction only, without affecting propagation in other directions, or the conductive element can block more than one direction.

The "enclosure" that at least partly blocks the propagation path can be relatively small and can function as an antenna that is driven from the source signal with a difference in phase. Such an embodiment is functionally similar to a phased array of antennas and causes the power spectrum emitted from the apparatus to have a limited angular span, whereas the source signal may otherwise have been emitted in all directions. According to the invention, such a phasing technique is used to improve the shielding performance of an apparatus as opposed to controlling the directionality of emissions. Noise induced by the source would be received and re-radiated by the outer enclosure in all directions. However inasmuch as the outer enclosure is coupled to the source signal by the phase shift circuit, the emissions are limited to propagation paths that are not blocked by the outer enclosure. In the event that the emissions from the source are not unidirectional to begin with (for example if a particular linear conductor is responsible for the greater part of the emissions), the outer enclosure can be provided to extend only in those directions where noise would be emitted (e.g., extending parallel to a plane of the linear conductor responsible for the noise). In this way, the emission of noise is controlled without providing a new source of noise radiation that does not sum to a null with induced noise (e.g., along the axis of the responsible linear conductor).

The cancellation signal can be active or passive. In one possible arrangement, shown in FIG. 4, a conductive enclosure 32 around a noise source 24 is actively driven to maintain a reference potential, using a differential amplifier 82 (an operational amplifier) as a follower amplifier whose reference input is coupled to a reference such as a ground connection 84. The output of the differential amplifier 82 is coupled to the conductive shield enclosure 32, which otherwise is at a floating potential rather than being grounded. That is, the conductive enclosure 32 has no substantial connection to ground other than through differential amplifier 82, connected as a follower to maintain the enclosure at the potential of the reference ground connection 84. Effectively, feedback to the operational amplifier is provided because the induced signal from the source is coupled to one of the operational amplifier inputs in a feedback loop that causes the amplifier to control its output, which is coupled to the conductive enclosure) to maintain the potential of its other input, coupled to the ground potential reference. This arrangement differs from directly grounding a shield enclosure because the inputs to the operational amplifier are high impedance inputs and there is no connection between the floating shield and ground other than the operational amplifier. The operational amplifier holds the potential of the shield enclosure to the potential of the reference. In actively driving the floating shield to maintain the reference potential, the differential amplifier 82 produces a signal that is 180 degrees out of phase with the noise signal induced in the conductive enclosure 32 by source 24. A similar arrangement can be used in an embodiment in which the conductive barrier is not a full sheet or enclosure, but instead encompasses a limited angular arc relative to the source, nevertheless tending to reduce the amplitude of emissions along a propagation path including the conductive barrier. The actively driven arrangement shown is different than a shield arrangement in which the conductive enclosure 32 is simply grounded, due to the high impedance of the connection to ground.

In any event, the invention as described provides an electrical circuit having minimized noise emissions, wherein a first circuit generates a substantially-periodic electromagnetic primary signal that would be received and reradiated by a substantially conductive body in proximity with the first circuit along a propagation path that can be a noise emission path. A phase shift circuit is responsive to the primary signal of the first circuit, whether sensed directly or indirectly, and produces a cancellation signal that is synchronous with the primary signal and out of phase with the current in the conductive body or at least one or more predetermined frequency components thereof. The cancellation signal is coupled to the conductive body and sums in the conductive body with the noise signal, preferably forming a null but at least reducing the amplitude of the noise signal. The result is the reduction or elimination of further radiation of the noise signal along the noise emission path.

The invention has been described in terms of exemplary embodiments, but is not limited to the example shown and discussed. The appended claims should be construed to include such other variants and embodiments of the invention as may be made by those skilled in the art without departing from the scope and reasonable range of equivalents of the invention taught and claimed.

## Claims

1. An apparatus for adjusting an extent of electrical emission from a first circuit that generates an substantially-periodic electromagnetic primary signal, the apparatus comprising:
a substantially conductive body in which the primary signal induces a noise signal synchronous with the primary signal;
a phase shift circuit coupled to the first circuit and operable to produce an interference signal that is synchronous with the primary signal, the interference signal being coupled to the conductive body to produce a cancellation signal that is out of phase with the noise signal and is summed with the noise signal in the conductive body, whereby the cancellation signal and the noise signal at least partly nullify one another, thereby reducing radiation of the noise signal beyond the conductive body.

2. The apparatus of claim 1, wherein the conductive body is at least partly comprised by a conductive shield at least partly enclosing the circuit.

3. The apparatus of claim 1, wherein the conductive body comprises a conductive barrier spaced from the circuit along a transmission path and said radiation of the noise signal beyond the conductive body is along the transmission path.

4. The apparatus of claim 3, wherein the conductive barrier comprises at least one of sheet metal, foraminous metal, fibrous metal, particulate conductive particles, conductive plastic, and conductively-coated plastic.

5. The apparatus of claim 1, wherein the noise signal is induced in the conductive body by the primary signal due to electromagnetic propagation from the circuit to the conductive body.

6. The apparatus of claim 1, wherein the noise signal is induced in the conductive body at least partly over a conductive path between the circuit and the conductive body.

7. The apparatus of claim 1, wherein the cancellation signal is phase shifted 180 degrees relative to the noise signal and is coupled to the conductive body over a conductive connection to the phase shift circuit.

8. The apparatus of claim 1, wherein the noise signal is attenuated relative to the primary signal and further comprising at least one attenuator between the circuit and the phase shift circuit

9. The apparatus of claim 1, wherein the noise signal has components at a plurality of frequencies, and the phase shift circuit is operable to provide said interference signal and said cancellation signal at least at two of said frequencies and out of phase with at least two corresponding said components.

10. The apparatus of claim 1, wherein the phase shift circuit comprises an inverter and attenuator operable to provide said cancellation signal at substantially equal amplitude and 180 degrees out of phase with the noise signal.

11. An electrical circuit having minimized noise emissions, comprising:
a first circuit that generates an substantially-periodic electromagnetic primary signal;
a substantially conductive body in proximity with the first circuit along a noise emission path, the primary signal electromagnetically inducing a current in the conductive body related to the primary signal;
a phase shift circuit coupled to the primary signal of the first circuit, the phase shift circuit producing a cancellation signal that is synchronous with the primary signal and out of phase with the current in the conductive body, said cancellation signal being coupled to the conductive body such that the cancellation signal and the noise signal are summed in the conductive body, thereby reducing or eliminating radiation of the noise signal along the noise emission path.

12. The electrical circuit of claim 11, wherein the conductive body comprises a conductive enclosure forming a shield that at least partly encloses the circuit.

13. The electrical circuit of claim 11, wherein the conductive body comprises a conductive barrier spaced from the circuit along the noise emission path.

14. The electrical circuit of claim 13, wherein the conductive body comprises at least one of sheet metal, foraminous metal, fibrous metal, particulate conductive particles, conductive plastic, and conductively-coated plastic, and wherein the conductive barrier is wired to the phase shift circuit for coupling the cancellation signal to the conductive

15. The electrical circuit of claim 14, wherein the cancellation signal is phase shifted substantially by 180 degrees relative to the noise signal.

16. The electrical circuit of claim 14, wherein the cancellation signal is inverted relative to the noise signal.

17. The electrical circuit of claim 14, wherein the noise signal is attenuated relative to the primary signal due to electromagnetic induction in the conductive body, and further comprising at least one attenuator coupled between the conductive body and the phase shift circuit

18. The electrical circuit of claim 17, wherein the attenuator is operable to attenuate an output of the phase shift circuit as a function of frequency, for producing the cancellation signal.
